# EUROPEAN PATENT APPLICATION

(11) **EP 4 836 298 A1**
(43) Date of publication of application: **04.11.2026**
(21) Application number: 24911419.0
(22) Date of filing: 27.12.2024
(51) Int. Cl.: H03H 9/25

(54) **RESONATOR HAVING TRANSVERSE-MODE SUPPRESSION STRUCTURE, AND METHOD FOR MANUFACTURING SAME**

(30) Priority: 28.12.2023 CN 202311849105
(71) Applicant: Maxscend Microelectronics Company Limited, Wuxi, Jiangsu 214000 (CN)
(72) Inventor: BARSUKOU, Siarhei, Wuxi, Jiangsu 214000 (CN); FUKUHARA, Hironori, Wuxi, Jiangsu 214000 (CN)
(74) Representative: Murgitroyd & Company
(86) International application number: PCT/CN2024/143030
(87) International publication number: WO 2025/140498

(57) **Abstract**

A resonator having a transverse-mode suppression structure includes a piezoelectric substrate, and an electrode layer, a passivation layer and a suppression layer that are located on the piezoelectric substrate. The electrode layer includes two interdigital electrodes arranged opposite to each other in a first direction. Each interdigital electrode includes a busbar and a plurality of electrode fingers connected to the busbar. A gap exists between each of the plurality of electrode fingers in one interdigital electrode and the busbar of the other interdigital electrode. The passivation layer is embedded between the two interdigital electrodes in the first direction and covers the electrode fingers and the gap. The suppression layer includes two suppression units arranged opposite to each other in the first direction. Each suppression unit is connected to the busbar of one interdigital electrode, extends along the first direction to cover the gap, and has a projection onto a plane in which the piezoelectric substrate is located that partially overlaps with a projection of at least one electrode finger of the other interdigital electrode onto the plane in which the piezoelectric substrate is located. The additionally provided suppression layer structure achieves suppression of a transverse mode while improving the quality factor, thereby enhancing operational stability and service life of a resonator.

## Description

### TECHNICAL FIELD

The present application belongs to the field of resonator technologies, and relates to a resonator having a transverse-mode suppression structure and a method for manufacturing same.

### BACKGROUND

During operation of a surface acoustic wave resonator, generation of a main mode is usually accompanied by generation of a transverse mode. The transverse mode is an undesirable mode in the surface acoustic wave resonator because the transverse mode negatively affects normal operation of the resonator. Therefore, how to achieve a good suppression effect on the transverse mode generated during operation of the resonator has become an important technical problem to be solved by those skilled in the art.

### SUMMARY

In view of this, an objective of the present application is to provide a resonator having a transverse-mode suppression structure and a method for manufacturing same, to solve a problem in the related art that a method for suppressing a transverse mode has limited a suppression effect on the transverse mode.

To achieve the above objective and other related objectives, the present application provides a resonator having a transverse-mode suppression structure, including: a piezoelectric substrate; an electrode layer located above the piezoelectric substrate, the electrode layer including two interdigital electrodes arranged opposite to each other in a first direction, each interdigital electrode of the two interdigital electrodes including a busbar and a plurality of electrode fingers connected to the busbar, the plurality of electrode fingers in a same interdigital electrode being spaced apart in a second direction, a gap being present between each electrode finger of the plurality of electrode fingers in one interdigital electrode and the busbar of the other interdigital electrode, and the second direction being perpendicular to the first direction; a passivation layer located above the piezoelectric substrate, the passivation layer being embedded between the two interdigital electrodes in the first direction and covering the gap and the plurality of electrode fingers of the two interdigital electrodes; and a suppression layer located above the piezoelectric substrate, the suppression layer including two suppression units arranged opposite to each other in the first direction, each suppression unit of the two suppression units being connected to the busbar of one interdigital electrode, extending along the first direction to cover the gap, and having a projection onto a plane in which the piezoelectric substrate is located that partially overlaps with a projection of at least one electrode finger of the other interdigital electrode onto the plane in which the piezoelectric substrate is located.

Optionally, when a spacing between two adjacent electrode fingers in a same interdigital electrode is λ, a width, in the first direction, of a portion in which the projection of the suppression unit on the plane in which the piezoelectric substrate is located partially overlaps with the projection of the at least one electrode finger of the other interdigital electrode on the plane in which the piezoelectric substrate is located is in a range of 0 to 1.0λ.

Optionally, a thickness, in a vertical direction, of a portion of the suppression unit located above the gap and above the at least one electrode finger of the other interdigital electrode is in a range of 1 nm to 100 nm, and the vertical direction is perpendicular to both the first direction and the second direction.

Optionally, the suppression unit is connected to a surface of the busbar of the one interdigital electrode facing away from the piezoelectric substrate and extends to above the passivation layer.

Optionally, in the vertical direction, a thickness of a portion of the suppression unit located above the busbar of the one interdigital electrode is greater than or equal to a thickness of a portion of the suppression unit located above the passivation layer.

Optionally, the suppression unit is further embedded in the passivation layer in the vertical direction, and a portion of the suppression unit embedded in the passivation layer in the vertical direction is located above the gap.

Optionally, the suppression unit is connected to a side surface of the busbar of the one interdigital electrode and is embedded in the passivation layer in the first direction.

Optionally, a portion of the suppression unit located above the gap has at least one blind slot, and each blind slot of the at least one blind slot opens from a surface of the suppression unit facing the piezoelectric substrate and/or a surface of the suppression unit facing away from the piezoelectric substrate, and extends in the vertical direction.

Optionally, a portion of the suppression unit located above the gap has at least one through slot, each through slot of the at least one through slot opens from a surface of the suppression unit facing away from the piezoelectric substrate, and the at least one through slot exposes at least a portion of at least one electrode finger of the one interdigital electrode.

Optionally, the passivation layer has a groove, a projection of the groove on the plane in which the piezoelectric substrate is located is located between projections of the two suppression units on the plane in which the piezoelectric substrate is located, and a portion of the passivation layer surrounding the groove constitutes a raised frame.

Optionally, a portion of the suppression unit located above the gap and above the at least one electrode finger of the other interdigital electrode includes a plurality of suppression blocks spaced apart in the second direction, and a projection of at least one suppression block of the plurality of suppression blocks on the plane in which the piezoelectric substrate is located partially overlaps with the projection of the at least one electrode finger of the other interdigital electrode on the plane in which the piezoelectric substrate is located.

Optionally, the plurality of suppression blocks includes a plurality of first suppression blocks, the plurality of first suppression blocks extend in the first direction above the gap, and projections of the plurality of first suppression blocks on the plane in which the piezoelectric substrate is located partially overlap with the projection of the at least one electrode finger of the other interdigital electrode on the plane in which the piezoelectric substrate is located.

Optionally, the plurality of suppression blocks further includes a plurality of second suppression blocks, and the plurality of second suppression blocks extend in the first direction above an electrode finger of the one interdigital electrode.

Optionally, in a same suppression unit, the plurality of first suppression blocks and the plurality of second suppression blocks are alternately arranged, and in different suppression units, the plurality of first suppression blocks and the plurality of second suppression blocks are arranged opposite to each other, and the plurality of first suppression blocks and the plurality of second suppression blocks have a same morphology.

Optionally, in a same suppression unit, the plurality of first suppression blocks and the plurality of second suppression blocks are alternately arranged, and in different suppression units, the plurality of first suppression blocks and the plurality of second suppression blocks are arranged opposite to each other, and the plurality of first suppression blocks and the plurality of second suppression blocks have different morphologies.

Optionally, the interdigital electrode further includes a plurality of dummy fingers connected to the busbar, and in a same interdigital electrode, the plurality of dummy fingers and the plurality of electrode fingers are alternately arranged at intervals, the plurality of dummy fingers are embedded in the gap, and a preset distance exists between the plurality of dummy fingers of one interdigital electrode and the plurality of electrode fingers of the other interdigital electrode.

Optionally, a material of the suppression layer includes at least one of a metallic material and a high-density dielectric material, the metallic material includes at least one of Al, Ti, Cu, Pt, and Au, and the high-density dielectric material includes at least one of Ta₂O₅, HfO₂, and BaTiO₃.

The present application also provides a method for manufacturing a resonator having a transverse-mode suppression structure, including: providing a piezoelectric substrate; forming an electrode layer above the piezoelectric substrate, the electrode layer including two interdigital electrodes arranged opposite to each other in a first direction, each interdigital electrode of the two interdigital electrodes including a busbar and a plurality of electrode fingers connected to the busbar, the plurality of electrode fingers in a same interdigital electrode being spaced apart in a second direction, a gap being present between each electrode finger of the plurality of electrode fingers in one interdigital electrode and the busbar of the other interdigital electrode, and the second direction being perpendicular to the first direction; forming a passivation layer above the piezoelectric substrate, the passivation layer being embedded between the two interdigital electrodes in the first direction and covering the gap and the plurality of electrode fingers of the two interdigital electrodes; and forming a suppression layer above the piezoelectric substrate, the suppression layer including two suppression units arranged opposite to each other in the first direction, each suppression unit of the two suppression units being connected to the busbar of one interdigital electrode, extending along the first direction to cover the gap, and having a projection onto a plane in which the piezoelectric substrate is located that partially overlaps with a projection of at least one electrode finger of the other interdigital electrode onto the plane in which the piezoelectric substrate is located.

As described above, in the resonator having the transverse-mode suppression structure of the present application, the additionally provided suppression layer structure achieves suppression of a transverse mode through energy confinement while also improving a quality factor of the resonator. The additionally provided suppression layer structure is applicable to various resonator structures and a wide frequency range, and does not require special high-resolution processes during manufacturing, thus having a simple structure and mature manufacturing processes. Furthermore, after further improvement and optimization of the suppression layer structure, a piston mode effect can be achieved without using a hammerhead structure or a selective removal method, reducing scattering loss. Additionally, selection of a material for the suppression layer allows the suppression layer to act as a heat sink due to its good thermal conductivity, in addition to a suppression effect of a transverse mode, thereby improving durability and linearity of the resonator, and consequently enhancing operational stability and service life of the resonator. The method for manufacturing the resonator having the transverse-mode suppression structure of the present application can effectively improve performance of the resonator structure without requiring special high-resolution processes. The process steps are simple and cost is low, thereby enabling mass production of high-performance resonators.

### BRIEF DESCRIPTION OF THE DRAWINGS

FIG. 1 shows a schematic structural partial top view of a resonator.
FIG. 2 shows a schematic diagram of the longitudinal cross-sectional structure taken along the I-I' in FIG. 1 and a corresponding change in acoustic wave propagation velocity.
FIG. 3 shows a schematic structural partial top view of a resonator having a transverse-mode suppression structure according to Embodiment 1 of the present application.
FIG. 4 shows a schematic diagram of the longitudinal cross-sectional structure taken along the II-II' in FIG. 3 and a corresponding change in acoustic wave propagation velocity.
FIG. 5 shows an enlarged schematic diagram of the first partial structure at the dashed box in FIG. 4.
FIG. 6 shows an effect curve diagram of conductance characteristics varying with frequency for a resonator having a transverse-mode suppression structure of the present application when a suppression unit partially overlaps with an electrode finger by different widths.
FIG. 7 shows an effect curve diagram of a quality factor Q varying with frequency for a resonator having a transverse-mode suppression structure of the present application when a suppression unit partially overlaps with an electrode finger by different widths.
FIG. 8 shows an effect curve diagram of conductance characteristics varying with frequency for a resonator having a transverse-mode suppression structure of the present application when a portion of a suppression unit located above a gap and above an electrode finger has different thicknesses.
FIG. 9 shows an effect curve diagram of a quality factor varying with frequency for a resonator having a transverse-mode suppression structure of the present application when a portion of a suppression unit located above a gap and above an electrode finger has different thicknesses.
FIG. 10 shows a schematic diagram of a negative linear relationship between a thickness of a passivation layer and a thickness of a suppression layer in a resonator having a transverse-mode suppression structure of the present application.
FIG. 11 shows an effect curve diagram of a quality factor Q varying with frequency for a resonator having a transverse-mode suppression structure of the present application under different passivation layer thicknesses.
FIG. 12 shows an enlarged schematic view of the second partial structure at the dashed box in FIG. 4.
FIG. 13 shows an enlarged schematic view of the third partial structure at the dashed box in FIG. 4.
FIG. 14 shows an enlarged schematic view of the fourth partial structure at the dashed box in FIG. 4.
FIG. 15 shows a schematic diagram of a partial longitudinal cross-sectional structure of a resonator having a transverse-mode suppression structure of the present application when the resonator has a dummy finger.
FIG. 16 shows a schematic structural top view of the electrode layer in the resonator shown in FIG. 15.
FIG. 17 shows a schematic diagram of a first partial longitudinal cross-sectional structure of a resonator having a transverse-mode suppression structure according to Embodiment 2 of the present application when a suppression unit is embedded in a passivation layer.
FIG. 18 shows a schematic diagram of a second partial longitudinal cross-sectional structure of a resonator having a transverse-mode suppression structure according to Embodiment 2 of the present application when a suppression unit is embedded in a passivation layer.
FIG. 19 shows a schematic diagram of a third partial longitudinal cross-sectional structure of a resonator having a transverse-mode suppression structure according to Embodiment 2 of the present application when a suppression unit is embedded in a passivation layer.
FIG. 20 shows a schematic diagram of a fourth partial longitudinal cross-sectional structure of a resonator having a transverse-mode suppression structure according to Embodiment 2 of the present application when a suppression unit is embedded in a passivation layer.
FIG. 21 shows a schematic structural top view of a resonator having a transverse-mode suppression structure according to Embodiment 3 of the present application when a suppression unit has a plurality of through slots.
FIG. 22 shows a schematic structural top view of a resonator having a transverse-mode suppression structure according to Embodiment 3 of the present application when a suppression unit has one through slot.
FIG. 23 shows a first schematic structural top view of a resonator having a transverse-mode suppression structure according to Embodiment 4 of the present application when a suppression unit includes a plurality of suppression blocks.
FIG. 24 shows a second schematic structural top view of a resonator having a transverse-mode suppression structure according to Embodiment 4 of the present application when a suppression unit includes a plurality of suppression blocks.
FIG. 25 shows a third schematic structural top view of a resonator having a transverse-mode suppression structure according to Embodiment 4 of the present application when a suppression unit includes a plurality of suppression blocks.
FIG. 26 shows a fourth schematic structural top view of a resonator having a transverse-mode suppression structure according to Embodiment 4 of the present application when a suppression unit includes a plurality of suppression blocks.
FIG. 27 shows a fifth schematic structural top view of a resonator having a transverse-mode suppression structure according to Embodiment 4 of the present application when a suppression unit includes a plurality of suppression blocks.
FIG. 28 shows a schematic flowchart of a method for manufacturing a resonator having a transverse-mode suppression structure of the present application.

### Description of component reference numerals

- 10: Piezoelectric substrate
- 20: Electrode layer
- 101, 21: Busbar
- 211: Lower busbar
- 212: Upper busbar
- 102, 22: Electrode finger
- 23: Gap
- 24: Dummy finger
- 30: Passivation layer
- 31: Groove
- 32: Raised frame
- 40: Suppression layer
- 41: Suppression unit
- 411: Blind slot
- 412: Through slot
- 413: Suppression block
- 413a: First suppression block
- 413b: Second suppression block

### DETAILED DESCRIPTION OF THE EMBODIMENTS

The following describes implementations of the present application through specific examples. Those skilled in the art can easily understand other advantages and effects of the present application from the content disclosed in this specification. The present application can also be implemented or applied through other different specific embodiments. Various details in this specification can also be modified or changed based on different viewpoints and applications without departing from the spirit of the present application.

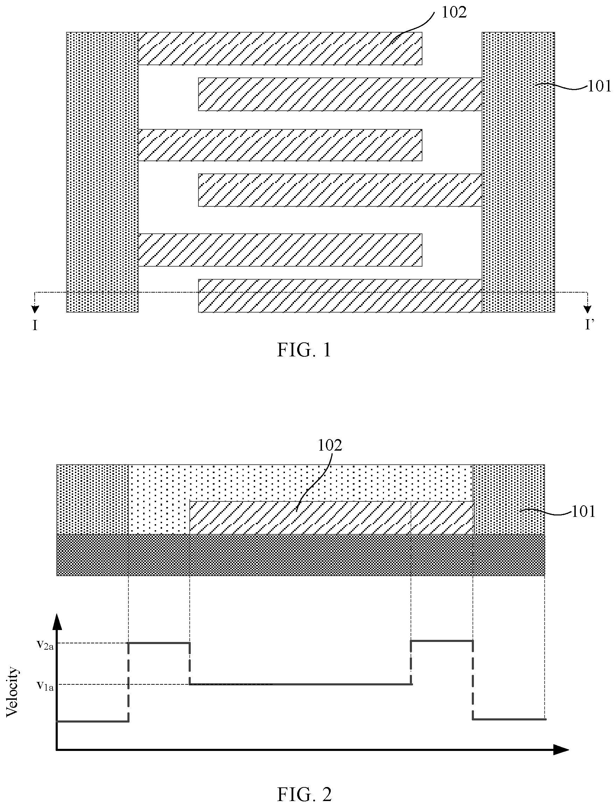

A surface acoustic wave resonator generally includes a substrate made of a piezoelectric material and at least two interdigital transducers located on the piezoelectric substrate and composed of multiple pairs of interdigitated conductive electrode fingers. Referring to FIG. 1 and FIG. 2, FIG. 1 shows a schematic structural partial top view of a resonator, and FIG. 2 shows a schematic diagram of the longitudinal cross-sectional structure taken along the I-I' in FIG. 1 and a corresponding change in acoustic wave propagation velocity. The interdigital transducer includes a busbar 101 and an electrode finger 102. The interdigital transducer performs conversion of electroacoustic signals through a piezoelectric effect, and a main mode therein is a surface acoustic wave. A surface acoustic wave resonator is a device system composed of two transducers and a piezoelectric substrate, and has a specific frequency response characteristic. This characteristic can be controlled by manipulating materials and structures of the transducers and the substrate. The device has advantages such as high stability, small volume, and a high-quality factor Q, and is thus widely used in various acoustic devices. For example, a radio frequency filter based on a surface acoustic wave resonator is commonly used in wireless communication equipment, and exhibits excellent performance by utilizing the surface acoustic wave resonator to meet requirements for increasing frequency bands and for radio frequency spectrum restrictions.

During operation of a surface acoustic wave resonator, generation of a main mode is usually accompanied by generation of a transverse mode, and the transverse mode propagates in a direction perpendicular to a propagation direction of the main mode. When a piezoelectric resonator or a radio frequency filter is composed of a plurality of surface acoustic wave resonator units, spurious resonance caused by the transverse mode can interfere with and distort a frequency response of the device, resulting in strong band noise in a transmit band, and poor insulation and suppression effects at a receiving end, thereby significantly reducing overall performance of a radio communication system. Currently, to reduce a negative impact of the transverse mode during the operation of the resonator, a common method is to suppress the transverse mode. For example, a mass loading block or a hammerhead is provided on an interdigital electrode, a shape of the interdigital electrode is adjusted to generate acoustic waves in different directions, and a structure of the interdigital electrode is adjusted and designed (e.g., providing a double-layer interdigital electrode) to obtain a piston mode effect. However, existing methods have more or less problems. For example, structural adjustment usually uses a high-resolution process and increases process difficulty and cost for manufacturing the resonator, increases an overall volume of the resonator, or has a limited suppression effect on the transverse mode and cannot effectively improve operating performance of the resonator while maintaining a high Q value.

Therefore, how to provide a resonator having a transverse-mode suppression structure and a method for manufacturing same, so as to achieve a good suppression effect on a transverse mode generated during operation of the resonator and improve a quality factor without additionally increasing process difficulty, has become an important technical problem to be solved by those skilled in the art.

It should be noted that the above description of the technical background is only for the convenience of clearly and completely explaining the technical solutions of the present application and facilitating the understanding of those skilled in the art. Therefore, the above technical solutions cannot be considered as known to those skilled in the art.

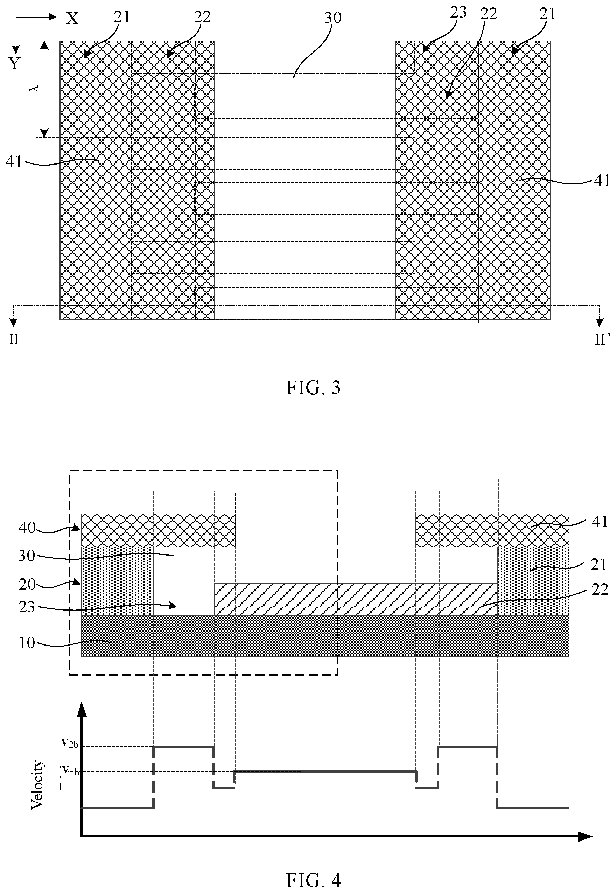

To solve the above problem, the present application provides a resonator having a transverse-mode suppression structure and a method for manufacturing same. Please refer to FIG. 3 to FIG. 27. It should be noted that the diagrams provided in the embodiments are only for schematically illustrating the basic concept of the present application. Therefore, the diagrams only show components related to the present application, and are not drawn according to the number, shape, and size of components in actual implementation. The type, quantity, and proportion of each component in actual implementation can be arbitrarily changed, and the component layout pattern may also be more complex.

### Embodiment 1

This embodiment provides a resonator having a transverse-mode suppression structure. Referring to FIG. 3 and FIG. 4, FIG. 3 shows a schematic structural top view of a resonator, and FIG. 4 shows a schematic diagram of the longitudinal cross-sectional structure taken along the II-II' in FIG. 3. The resonator includes a piezoelectric substrate 10, an electrode layer 20, a passivation layer 30, and a suppression layer 40.

Specifically, the electrode layer 20 is located above the piezoelectric substrate 10. The electrode layer 20 includes two interdigital electrodes arranged opposite to each other in a first direction (shown as the direction X in FIG. 3). Each interdigital electrode includes a busbar 21 and a plurality of electrode fingers 22. In a same interdigital electrode, the plurality of electrode fingers 22 are arranged at intervals in a second direction (shown as the direction Y in FIG. 3) and are all connected to the busbar 21. A gap 23 is provided between the electrode finger 22 of one interdigital electrode and the busbar 21 of the other interdigital electrode. The second direction is perpendicular to the first direction. The passivation layer 30 is located above the piezoelectric substrate 10. The passivation layer 30 is embedded between the two interdigital electrodes in the first direction and covers the electrode fingers 22 and the gap 23. The suppression layer 40 is located above the piezoelectric substrate 10. The suppression layer 40 includes two suppression units 41 arranged opposite to each other in the first direction. Each suppression unit 41 is connected to one busbar 21 and extends along the first direction to cover the gap 23 and partially overlaps with at least one electrode finger 22 on a different side of the suppression unit 41. That is, each of the two suppression units 41 is connected to the busbar 21 of one interdigital electrode and extends along the first direction to cover the gap 23, and a projection of the suppression unit 41 on the plane where the piezoelectric substrate 10 is located partially overlaps with a projection of at least one electrode finger 22 of the other interdigital electrode on the plane where the piezoelectric substrate 10 is located.

Specifically, in the resonator structure of this embodiment, the suppression layer 40 is additionally provided on the basis of a conventional resonator structure, so that the suppression layer 40 is connected to the busbar 21 and extends to above the gap 23 and above an edge region of the electrode finger 22. This includes both a case in which the suppression unit 41 exactly extends to an edge of the electrode finger 22 and a case in which the suppression unit 41 further extends to above the electrode finger 22. That is, the suppression layer 40 can be regarded as an extended structure of the busbar 21. As can be seen from an acoustic velocity change diagram in FIG. 4, a propagation velocity of an acoustic velocity in a region in which the suppression unit 41 overlaps with the electrode finger 22 is significantly lower than a propagation velocity of an acoustic velocity in a main region of the electrode finger 22, namely a region not covered by the suppression layer 40. Moreover, compared with a distribution trend of a surface acoustic wave propagation velocity in the conventional resonator structure, when propagation velocities of the acoustic wave in regions of the electrode finger 22 are the same (i.e., when V₁ₐ in FIG. 2 is equal to V_{1b} in FIG. 4), a propagation velocity of the acoustic wave in a region where the gap 23 is located is relatively reduced (i.e., V_{2b} in FIG. 4 is less than V₂ₐ in FIG. 2). After analysis, it is considered that the foregoing acoustic wave propagation velocity exists because based on acoustic interaction and a phase shift effect between the suppression layer 40 and the surface acoustic wave, a transverse spurious mode whose propagation direction is perpendicular to the propagation direction of the surface acoustic wave presents non-uniform acoustic impedance interaction in an edge region of the electrode finger 22 (i.e., a partial overlapping region) and the region of the gap 23, and a large amount of acoustic spurious energy is introduced into the passivation layer 30 through the phase shift effect, thereby suppressing interference caused by the transverse mode to performance of the resonator. In addition, by improving and optimizing the suppression structure, a piston mode effect can be introduced on the basis of the basic structure to further enhance operating performance of the resonator (see below for details).

As an example, a material of the piezoelectric substrate 10 includes, but is not limited to, 128Y-cut lithium niobate (LN) material.

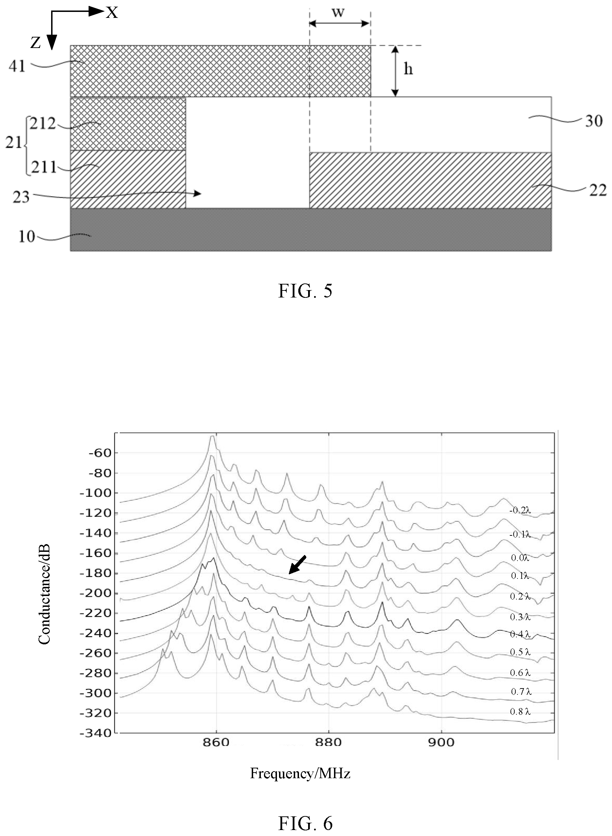

As an example, referring to FIG. 5, which shows an enlarged schematic diagram of the first partial structure at the dashed box in FIG. 4, in a vertical direction (i.e., the direction Z shown in FIG. 5), a height of the busbar 21 is greater than a height of the electrode finger 22, and the passivation layer 30 is embedded in a region between two busbars 21. In other embodiments, the passivation layer 30 may alternatively be partially embedded in a region where the busbar 21 is located without completely covering the busbar 21. During actual application, the structure of the passivation layer can be modified based on actual needs. That the height of the busbar 21 is greater than the height of the electrode finger 22 may be understood as that the busbar 21 includes a lower busbar 211 flush with the electrode finger 22 in the vertical direction and an upper busbar 212 located above the lower busbar 211. Further, a material of the upper busbar 212 is the same as or different from a material of the lower busbar 211. In this embodiment, the material of the upper busbar 212 is different from the material of the lower busbar 211, and in the vertical direction, a thickness of the upper busbar 212 is greater than a thickness of the lower busbar 211. That is, the busbar 21 has a stacked structure, which can achieve region characteristics of low speed and lossy (high damping). In this case, the structure of the suppression layer 40 is first optimized to achieve an optimal piston mode effect, and then complete spurious suppression is achieved by adjusting the region of the gap 23. It should be noted that although the upper busbar 212 and the lower busbar 211 are not distinguished in the subsequent drawings, this does not mean that the materials of the upper busbar 212 and the lower busbar 211 are the same.

As an example, a material of the passivation layer 30 includes at least one of SiO₂, SiN, or other dielectric materials with positive thermal velocity characteristics. In this embodiment, the material of the passivation layer is SiO₂. The provision of the suppression layer 40 can, on the one hand, provide electrical insulation between the suppression layer 40 and the electrode finger 22, and on the other hand, serve as an acoustic guide layer to allow the surface acoustic wave to propagate in the passivation layer 30 and reduce transverse energy diffusion during operation of the resonator. In addition, a surface of the passivation layer 30 facing away from the piezoelectric substrate 10 maintains a flat surface (which can be achieved by planarization treatment after fabrication), thereby reducing unnecessary scattering loss generated when the suppression layer 40 is formed thereon, and further improving operating performance of the resonator. In this embodiment, the material of the passivation layer 30 is SiO₂, and in the vertical direction, a thickness of the passivation layer 30 is 1 µm.

As an example, a material of the electrode layer 20 includes one or more of metallic materials such as Al, Ti, Cu, Pt, and Au. In this embodiment, the material of the electrode layer 20 is Cu.

As an example, a material of the suppression layer 40 includes at least one of a metallic material and a high-density dielectric material. The metallic material includes at least one of Al, Ti, Cu, Pt, and Au. The high-density dielectric material includes at least one of Ta₂O₅, HfO₂, and BaTiO₃. The three high-density dielectric materials have relatively high densities, and relative densities greater than 6.0 g/cm³. Using the above materials to form the suppression layer 40 can bring a certain mass loading effect (a phase shift effect) to achieve a piston mode, thereby reducing a velocity of the transverse mode and further improving use performance of the resonator. The material of the suppression layer 40 is preferably the metallic material to simultaneously achieve a heat sink function. Further, the material of the suppression layer 40 can be the same as or different from the material of the electrode layer 20. In this embodiment, the material of the suppression layer 40 is the same as the material of the upper busbar 21.

Specifically, in this embodiment, the suppression layer 40 is made of the metallic material, so that, on the one hand, the suppression layer 40 is connected to the busbar 21 to improve electric field distribution in the region of the gap 23 based on an electrostatic effect generated by electrical interaction in a region in which the suppression layer 40 overlaps with an edge of the electrode finger 22, and to reduce higher-order nonlinearity and distortion of signal transmission by using an electrical effect presented by potential linearization of electric field in the region, and to suppress a transverse spurious mode based on acoustic interaction and a phase shift effect between the suppression layer 40 and the surface acoustic wave, thereby improving operating performance of the resonator. On the other hand, material characteristics of the suppression layer 40 give it good thermal conductivity, allowing it to function as a heat sink, thereby further improving durability and linearity of the resonator, and thus improving operational stability and service life of the resonator without additionally providing a heater structure, so as to avoid an increase in an overall volume of the resonator. Of course, in other embodiments, one or more of the high-density dielectric materials described above can also be used as the constituent material of the suppression layer 40, which can also achieve an effect of suppressing the transverse spurious mode and improving operating performance of the resonator. The material of the suppression layer 40 is preferably the metallic material to simultaneously achieve a heat sink function. During application, the material of the suppression layer 40 is reasonably selected based on actual needs.

As an example, when a spacing between two adjacent electrode fingers 22 in a same interdigital electrode is λ (shown by λ in FIG. 3), a width (shown by w in FIG. 5), in the first direction, of a portion in which the suppression unit 41 partially overlaps with the electrode finger 22 ranges from 0 to 1.0λ, including but not limited to 0, 0.3λ, 0.5λ, 0.8λ, or 1.0λ. The region where the suppression unit 41 partially overlaps with the electrode finger 22 is very important for achieving the piston mode effect and transverse suppression. In this region, a propagation velocity of the surface acoustic wave is significantly lower than that in the main region of the electrode finger 22, thereby achieving the piston mode effect. It should be noted that a propagation velocity of the surface acoustic wave in the region of the gap 23 also decreases, but has a relatively small effect on the transverse suppression, and a propagation velocity of the surface acoustic wave in a busbar region is very low, so an adverse effect brought by the thin suppression layer 40 can be ignored.

Referring to FIG. 6, FIG. 6 shows an effect curve diagram of conductance characteristics of the resonator varying with frequency when the suppression unit partially overlaps with the electrode finger by different widths. When the width of the partial overlap is less than 0 (e.g., -0.1λ), it means that the suppression unit 41 does not extend above the electrode finger 22 (i.e., the suppression unit 41 does not partially overlap with the electrode finger 22 in the first direction). When the width of the partial overlap is greater than 0 (e.g., 0.1λ), it means that the suppression unit 41 extends above the electrode finger 22 (i.e., the suppression unit 41 partially overlaps with the electrode finger 22 in the first direction). In a case in which other parameters are kept consistent, after the conductance characteristics of the resonator having different widths of the partial overlap between the suppression unit 41 and the electrode finger 22 are compared, it is found that the transverse mode of the resonator is suppressed to different degrees at different foregoing widths. When the suppression unit 41 partially overlaps with the electrode finger 22, the suppression effect on the transverse mode is relatively obvious, compared with a case in which the suppression unit 41 only extends to above a portion of the gap 23. Especially when the width of the partial overlap between the suppression unit 41 and the electrode finger 22 is 0.2λ, the effect is optimal. In this case, the transverse mode is almost completely suppressed in a frequency range of 860 MHz to 880 MHz, thereby effectively improving operating performance of the resonator. It should be noted that although related data curves when the width of the partial overlap is greater than 0.8λ are not compared in FIG. 5, actually when the width of the partial overlap is greater than 0.8λ, a certain transverse mode suppression effect is also achieved.

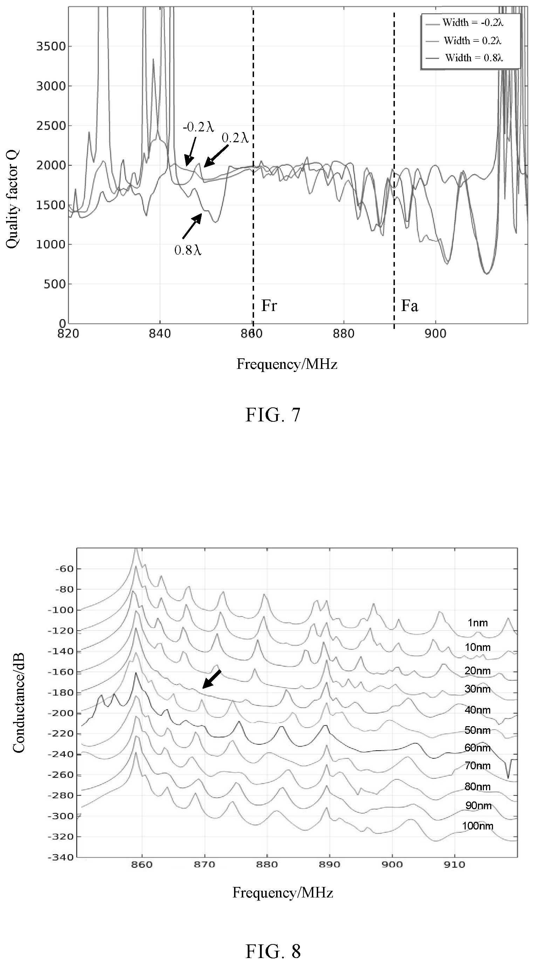

In addition, referring to FIG. 7, FIG. 7 shows an effect curve diagram of a quality factor Q of the resonator varying with frequency when the suppression unit partially overlaps with the electrode finger by different widths, where Fr and Fa in FIG. 7 respectively correspond to a resonant frequency and an anti-resonant frequency of the resonator. It can be seen from FIG. 7 that the quality factor Q of the resonator does not change significantly due to changes in the width of the partial overlap between the suppression unit 41 and the electrode fingers 22, namely the partial overlap between the suppression unit 41 and the electrode finger 22 does also not affect the quality factor Q of the resonator. It should be noted that when a width range of the above partial overlap is relatively small, the suppression unit 41 is mainly distributed above the gap 23, and electrostatic interaction between the suppression unit 41 and the periodically arranged electrode fingers 22 are relatively small. In this case, an impact of the electrostatic interaction between the two on performance of the resonator may be ignored. However, as the width range of the partial overlap gradually increases, the electrostatic interaction between the suppression unit 41 and the periodically arranged electrode fingers 22 also gradually increase, and an impact on an operation process of the resonator becomes increasingly prominent. Therefore, the width of the partial overlap between the suppression unit 41 and the electrode finger 22 is strictly limited to the above interval range, and is preferably 0.1λ to 0.5λ (including endpoint values). In addition, the arrangement of the suppression unit 41 provides a transitional buffering effect on the acoustic wave propagation velocity, thereby ensuring operating stability of the resonator.

As an example, a thickness (h in FIG. 5), in the vertical direction, of a portion of the suppression unit 41 located above the gap 23 and above the electrode finger 22 ranges from 1 nm to 100 nm, including but not limited to 1 nm, 25 nm, 40 nm, 75 nm, or 100 nm. When a thickness of the suppression unit 41 is uniform everywhere, a thickness of a portion of the suppression unit 41 located above the busbar 21 also ranges from 1 nm to 100 nm.

Referring to FIG. 8, FIG. 8 shows an effect curve diagram of conductance characteristics of the resonator varying with frequency when the portion of the suppression unit located above the gap and above the electrode finger has different thicknesses. In a case in which other parameters are kept consistent, for example, the width of the partial overlap between the suppression unit 41 and the electrode finger 22 is kept unchanged at 0.2λ, after the conductance characteristics of resonator having different foregoing thicknesses are compared, it is found that the transverse mode of the resonator is suppressed to different degrees at the different foregoing thicknesses. When the foregoing thickness is in a range of 20 nm to 60 nm, the transverse mode suppression effect is relatively good, and when the foregoing thickness is 40 nm, the transverse mode generated during operation of the resonator is completely suppressed, shown by an arrow in FIG. 8.

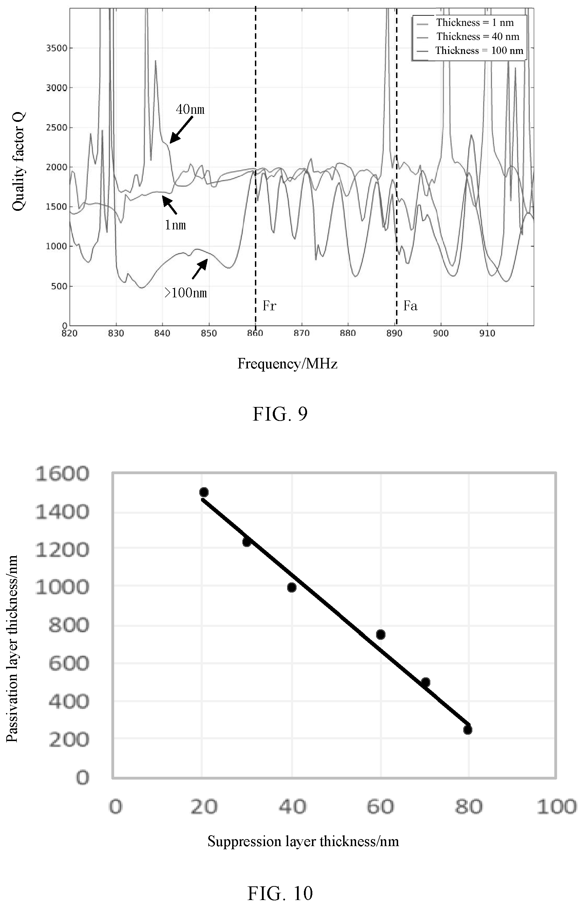

In addition, referring to FIG. 9, FIG. 9 shows an effect curve diagram of a quality factor Q of the resonator varying with frequency when the portion of the suppression unit located above the gap and above the electrode finger has different thicknesses. After the quality factor Q of the resonator is synchronously analyzed, it can be learned that as the foregoing thickness increases, an acoustic impact phenomenon generated in a corresponding suppression layer 41 intensifies, thereby causing a downward trend of the quality factor Q of the resonator. When the foregoing thickness is 1 nm, because the very thin suppression layer 41 does not generate acoustic impact, the quality factor Q remains in a relatively high state. When the foregoing thickness is relatively large, for example, greater than or equal to 100 nm, the acoustic impact generated by the suppression layer 41 is rather high, causing an obvious downward trend of the quality factor Q. It can be seen from FIG. 9 that when the foregoing thickness is 40 nm, a decrease amplitude of the quality factor Q of the resonator may be ignored, and the quality factor Q is even better in a low frequency region, for example, less than or equal to 840 MHz.

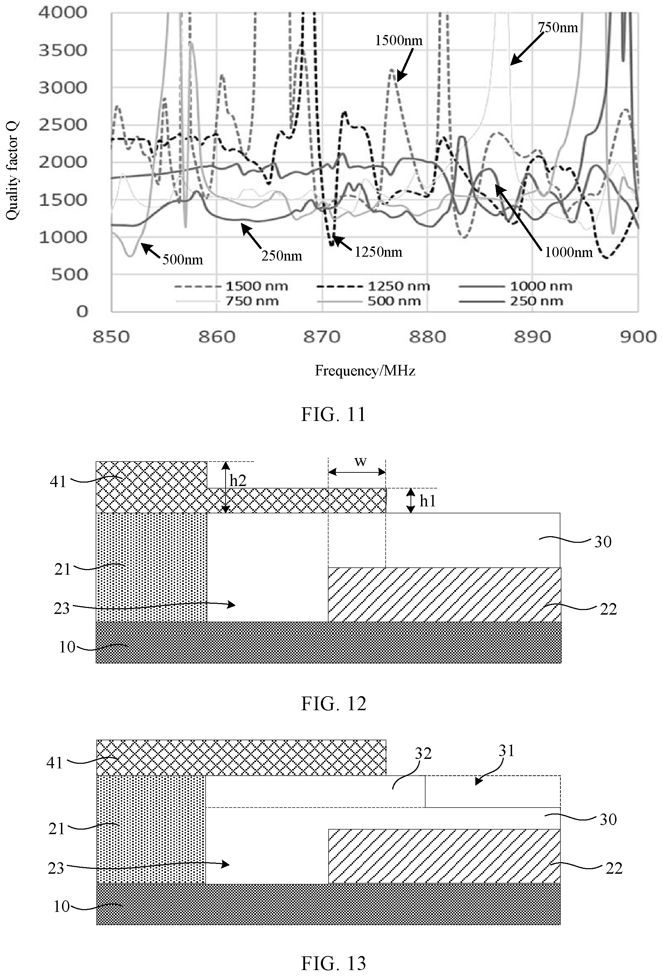

Further, after performance of the resonator having the suppression layer 41 and the passivation layer 30 with different foregoing thicknesses is analyzed, the following rules are summarized. To achieve a better transverse mode suppression effect, it is necessary to ensure that the thickness of the passivation layer 30 and the foregoing thickness of the suppression layer 40 present a negative linear correlation, as shown in FIG. 10. Therefore, in actual application, if the thickness of the passivation layer 30 is relatively small, the thickness of the suppression layer 40 is correspondingly increased; and when the thickness of the passivation layer 40 is relatively large, the thickness of the suppression layer 40 is correspondingly reduced. For example, when the passivation layer 30 is relatively thick, for example, about 1450 nm, the suppression layer 40 has a relatively small thickness, for example, about 20 nm, to achieve a better suppression effect. Referring to FIG. 11, FIG. 11 shows an effect curve diagram of a quality factor Q of the resonator varying with frequency under different passivation layer thicknesses. It should be noted that the data in FIG. 10 and FIG. 11 are collected when the width of the partial overlap between the suppression unit 41 and the electrode finger 22 is 0.2λ. The quality factor Q of the resonator does not significantly decrease due to different thicknesses of the passivation layer 30. When the thickness of the passivation layer 30 is relatively large, greater than or equal to 1250 nm, an increased spurious phenomenon presented by a corresponding curve in FIG. 11 is caused by failure to reasonably adjust a width of the suppression unit 41 located above the gap 23 and above the electrode finger 22. Therefore, when the resonator structure is designed, the thickness of the suppression layer 40( especially the thickness of the portion of the suppression unit 41 located above the gap 23 and above the electrode finger 22), the width range of the partial overlap between the suppression unit 41 and the electrode finger 22, and the thickness of the corresponding passivation layer 30 are simultaneously optimized, to ensure that the resonator has better performance.

As an example, referring to FIG. 5 and FIG. 12 to FIG. 14, the suppression unit 41 is connected to a surface of the busbar 21 away from the piezoelectric substrate 10 and extends to above the passivation layer 30. In other words, in this embodiment, in addition to the portion located above the gap 23 and the electrode finger 22, the suppression unit 41 further includes a portion located above the busbar 21.

Further, as shown in FIG. 5 and FIG. 13, in the vertical direction, a thickness of the portion of the suppression unit 41 located above the busbar 21 is equal to a thickness of a portion of the suppression unit 41 located above the passivation layer 30. Alternatively, as shown in FIG. 12, in the vertical direction, a thickness (shown by h2 in FIG. 12) of the portion of the suppression unit 41 located above the busbar 21 is greater than a thickness (shown by h1 in FIG. 12) of a portion of the suppression unit 41 located above the passivation layer 30, namely the portion of the suppression unit 41 located above the gap 23 and above the electrode finger 22.

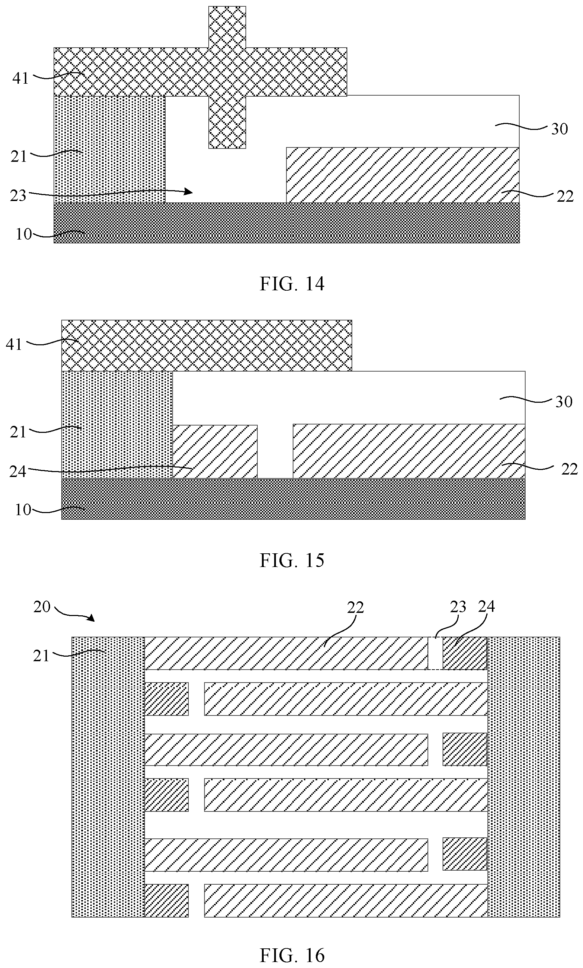

As an example, as shown in FIG. 14, the suppression unit 41 is further embedded in the passivation layer 30 in the vertical direction, and a portion of the suppression unit 41 embedded in the passivation layer 30 in the vertical direction is located above the gap 23. After an opening is formed by etching the manufactured passivation layer 30, the foregoing structure can be easily formed by completely filling the opening with the material of the suppression layer 40. In other words, an additional structure is filled above the gap 23, so that the structure performs an energy confinement function, thereby improving the quality factor Q, durability, and linearity of the resonator. In addition, the portion of the suppression unit 41 vertically extending into the passivation layer 30 is located near the electrode finger 22, which may also function as a dummy finger, to reduce scattering energy loss and further improve performance of the resonator.

As an example, as shown in FIG. 13, the passivation layer 30 has a groove 31, and a vertical projection of the groove 31 is located between vertical projections of the two suppression units 41. A portion of the passivation layer 30 surrounding the groove 31 forms a raised frame 32. During actual manufacturing, the foregoing structure can be implemented by patterning the passivation layer 30, or even the suppression layer 40. The raised frame 32 can limit, to a certain degree, an acoustic wave propagation velocity in a corresponding region of the gap 23 and an edge region of the electrode finger 22, to suppress the transverse mode. Correspondingly, the groove 31 can relatively increase an acoustic wave propagation velocity of a portion of the electrode finger 22 located below the groove 31, thereby specifically improving performance of the resonator.

As an example, referring to FIG. 15 and FIG. 16, FIG. 15 shows a schematic diagram of a partial longitudinal cross-sectional structure of the resonator when the resonator has a dummy finger, and FIG. 16 shows a schematic structural top view of the electrode layer in the resonator shown in FIG. 15. The interdigital electrode further includes a plurality of dummy fingers 24 connected to the busbar 21. In a same interdigital electrode, the plurality of dummy fingers 24 and the plurality of electrode fingers 22 are alternately arranged at intervals, and the dummy fingers 24 are embedded in the gap 23. A preset distance exists between the dummy fingers 24 of one interdigital electrode and the electrode fingers 22 of the other interdigital electrode, namely the dummy fingers 24 are located in the gap 23 and an end of a dummy finger 24 away from the busbar 21 is kept at a certain distance from an electrode finger 22 of the other interdigital electrode. Provision of the dummy fingers 24 can obtain a better energy confinement effect. In addition, parameters such as a width, a thickness, and a material of the dummy finger 24 are preferably kept consistent with corresponding parameters of the electrode finger 22, so that the dummy fingers 24 and the electrode fingers 22 can be simultaneously manufactured in one process step during manufacturing.

As an example, the resonator includes at least one of a temperature compensated surface acoustic wave resonator (TC-SAW), a piezoelectric on insulator-surface acoustic wave resonator (POI-SAW), a solidly mounted resonator (SMR), a transversely excited bulk acoustic resonator (XBAR), a longitudinally coupled bulk acoustic wave resonator (YBAR), and a film bulk acoustic resonator (FBAR).

In the resonator having the transverse-mode suppression structure of this embodiment, the additionally provided suppression layer structure achieves suppression of the transverse mode through energy confinement, while also improving the quality factor of the resonator. The additionally provided suppression layer structure is applicable to various resonator structures and a wide frequency range, and does not require special high-resolution processes during manufacturing, thus having a simple structure and mature manufacturing processes. Furthermore, after further improvement and optimization of the suppression layer structure, a piston mode effect can be achieved without using a hammerhead structure or a selective removal method, reducing scattering loss. Additionally, selection of a material for the suppression layer allows the suppression layer to act as a heat sink due to its good thermal conductivity, in addition to a suppression effect of a transverse mode, thereby improving durability and linearity of the resonator, and consequently enhancing operational stability and service life of the resonator. Moreover, a plurality of dummy finger structures are additionally provided in the interdigital electrode structure without additionally increasing an overall volume of the resonator, so that energy during operation of the resonator can be better confined and volume utilization is also improved, thereby further improving operating performance of the resonator.

### Embodiment 2

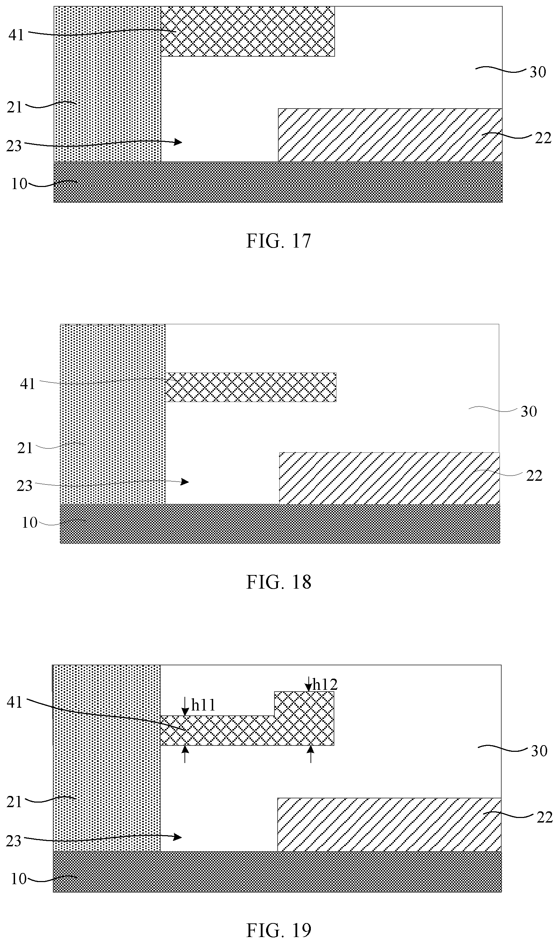

This embodiment provides a resonator having a transverse-mode suppression structure. A difference between this embodiment and Embodiment 1 lies in that in the resonator in Embodiment 1, the suppression unit is connected to a surface of the busbar away from the piezoelectric substrate and extends to above the passivation layer, whereas in the resonator in this embodiment, the suppression unit is connected to a side surface of the busbar and is embedded in the passivation layer in the first direction. Referring to FIG. 17 to FIG. 20, the resonator includes a piezoelectric substrate 10, an electrode layer 20, a passivation layer 30 (refer to FIG. 4 together), and a suppression layer 40 (refer to FIG. 4 together).

As an example, the suppression unit 41 is connected to a side surface of the busbar 21 and is embedded in the passivation layer 30 in the first direction. In other words, the suppression unit 41 is located only above the gap 23 and above the electrode finger 22, and does not include a portion located above the busbar 21. In this embodiment, the suppression unit 41 is embedded in the passivation layer 30. Compared with a solution in which the suppression unit 41 is located above the passivation layer 30, namely the solution described in Embodiment 1, the portion of the suppression unit 41 embedded in the passivation layer 30 can provide a better spurious mode suppression effect. However, when a structure with the embedded suppression unit 41 is used, influence of thickness designs of the passivation layer 30 and the suppression layer 40 on performance of the resonator needs to be comprehensively considered. For example, when the suppression unit 41 is completely embedded in the passivation layer 30, the suppression layer 40 further needs to have a relatively small thickness while satisfying a good transverse mode suppression effect; otherwise, an overall thickness of the passivation layer 30 is relatively large, which causes unnecessary loss to operating performance of the resonator.

Further, in the vertical direction, a thickness of a portion of the suppression unit 41 located above the gap 23 is less than a thickness of a portion of the suppression unit 41 located above the electrode finger 22, shown by h12 > h11 in FIG. 19. Alternatively, in the vertical direction, a thickness of a portion of the suppression unit 41 located above the gap 23 is equal to a thickness of a portion of the suppression unit 41 located above the electrode finger 22, as shown in FIG. 17 and FIG. 18. Thickening the portion of the suppression unit 41 located above the electrode finger 22, shown by comparison between FIG. 18 and FIG. 19, can further improve the transverse mode suppression effect and energy confinement effect. Correspondingly, however, additional process steps or costs are increased. Therefore, selection is made according to actual needs during application.

In the resonator having the transverse-mode suppression structure of this embodiment, based on the resonator structure in Embodiment 1, a positional relationship between the suppression unit and the passivation layer is flexibly set, thereby specifically adjusting performance parameters of the resonator to meet requirements of multiple application scenarios.

It should be understood that the vertical direction mentioned above refers to a direction from the piezoelectric substrate 10 to the suppression layer 40 or a direction from the suppression layer 40 to the piezoelectric substrate 10. The vertical direction, namely the direction Z in FIG. 5, is perpendicular to both the first direction, namely the direction X in FIG. 3 and FIG. 5, and the second direction, namely the direction Y in FIG. 3.

### Embodiment 3

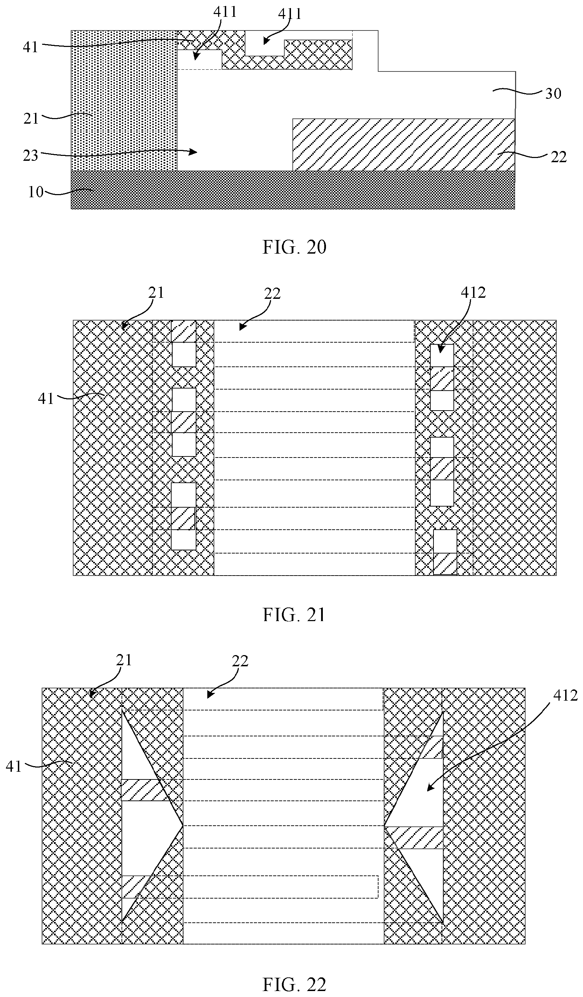

This embodiment provides a resonator having a transverse-mode suppression structure. A difference between this embodiment and Embodiment 1 and Embodiment 2 lies in that the suppression unit in the resonator described in Embodiment 1 and Embodiment 2 does not have a blind slot or a through slot, whereas the suppression unit in the resonator in this embodiment has a blind slot or a through slot. Referring to FIG. 20 to FIG. 22, the resonator includes a piezoelectric substrate 10, an electrode layer 20, a passivation layer 30 (refer to FIG. 4 together), and a suppression layer 40 (refer to FIG. 4 together).

As an example, referring to FIG. 20 to FIG. 22, a portion of the suppression unit 41 located above the gap 23 has at least one blind slot 411 and/or at least one through slot 412. The blind slot 411 opens from a surface of the suppression unit 41 facing the piezoelectric substrate 10 and/or a surface of the suppression unit 41 away from the piezoelectric substrate 10, and extends vertically. The through slot 412 opens from a surface of the suppression unit 41 away from the piezoelectric substrate 10 and exposes at least a portion of at least one electrode finger 22.

As shown in FIG. 20, the portion of the suppression unit 41 located above the gap 23 has two blind slots 411, and the two blind slots 411 keep a distance in the first direction and respectively open from different surfaces of the suppression unit 41. The blind slots 411 may be provided by designing details of a specific structure of the portion of the suppression unit 41 located above the gap 23, or even a portion located above the electrode finger 22, so as to specifically change effects of a local structure on transverse suppression and energy confinement, thereby adaptively adjusting performance parameters of the resonator.

As shown in FIG. 21, the portion of the suppression unit 41 located above the gap 23 has a plurality of through slots 412, the plurality of through slots 412 are spaced apart in the second direction, and each through slot 412 exposes at least a portion of the electrode finger 22. After the suppression layer 40 is manufactured, the foregoing structure can be obtained by patterning the suppression layer 40. The foregoing structure can not only control an acoustic wave propagation velocity in an edge region of the electrode finger 22, but also control an acoustic wave propagation velocity in a region of the gap 23, thereby reducing scattering loss and limiting energy leakage, to improve performance of the resonator.

As shown in FIG. 22, the portion of the suppression unit 41 located above the gap 23 has one through slot 412. The through slot 412 occupies nearly half of an area of the suppression unit 41 located above the gap 23 and is triangular. The through slot 412 enables the suppression unit 41 to be apodized, so that energy transmitted through the interdigital electrode is concentrated in a region of the electrode finger 22, to reduce energy loss and further improve performance of the resonator.

In the resonator having the transverse-mode suppression structure of this embodiment, based on the resonator structures of Embodiments 1 and 2, the structure of the suppression unit is diversely designed, to further improve operating performance of the resonator.

### Embodiment 4

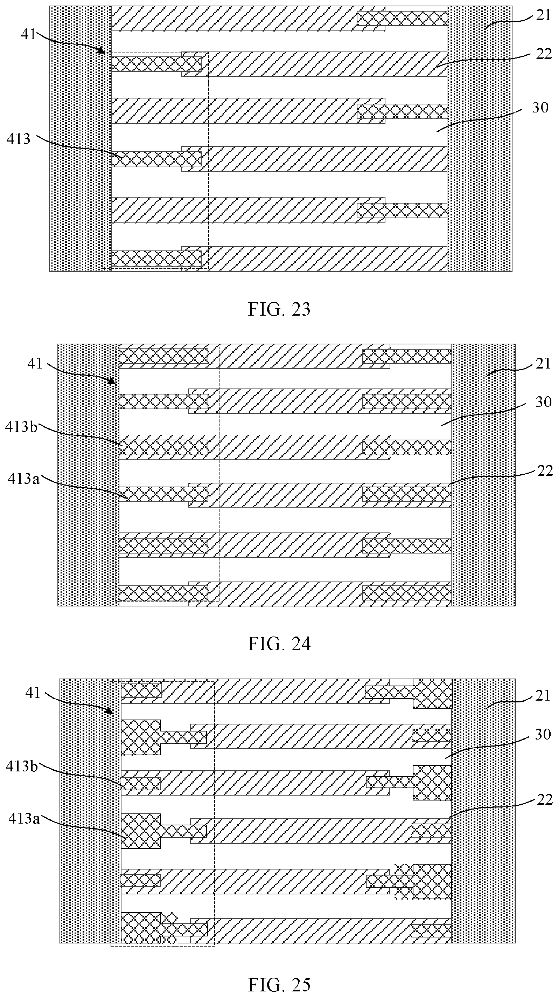

This embodiment provides a resonator having a transverse-mode suppression structure. A difference between this embodiment and Embodiment 1 and Embodiment 2 lies in that a portion of the suppression unit located above the gap and above the electrode finger in the resonator described in Embodiment 1 and Embodiment 2 is an integral structure, whereas a portion of the suppression unit located above the gap and above the electrode finger in the resonator in this embodiment includes a plurality of separately disposed suppression blocks. Referring to FIG. 23 to FIG. 27, the resonator includes a piezoelectric substrate 10, an electrode layer 20, a passivation layer 30 (refer to FIG. 4 together), and a suppression layer 40 (refer to FIG. 4 together).

As an example, a portion of the suppression unit 41 located above the gap 23 and the electrode finger 22 includes a plurality of suppression blocks 413 spaced apart in the second direction. A projection of at least one suppression block 413 on a plane in which the piezoelectric substrate 10 is located partially overlaps with a projection of an electrode finger 22 located on a different side of the suppression block 413 on the plane in which the piezoelectric substrate 10 is located. In other words, the projection of the at least one suppression block 413 of the suppression unit 41 connected to the busbar 21 of one interdigital electrode on the plane in which the piezoelectric substrate 10 is located partially overlaps with the projection of the electrode finger 22 of the other interdigital electrode on the plane in which the piezoelectric substrate 10 is located.

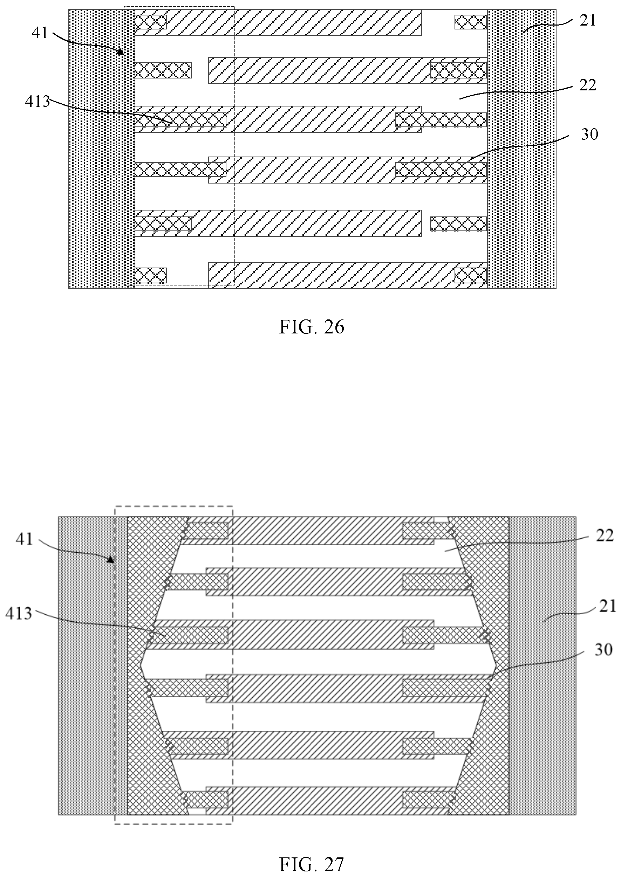

As an example, as shown in FIG. 23 and FIG. 24, each suppression block 413 has a same size, namely length, width, and thickness, and the suppression blocks 413 in a same suppression unit 41 are aligned. Alternatively, as shown in FIG. 25 and FIG. 26, the suppression blocks 413 have different sizes, but the plurality of suppression blocks 413 are symmetrically distributed about a central axis of the resonator in the first direction, and as shown in FIG. 26, two suppression units 41 are symmetrically distributed about the central axis of the resonator in the second direction. For example, a length of a suppression block 413 is inversely proportional to a distance between the suppression block 413 and a position near a center.

As an example, as shown in FIG. 23 to FIG. 25, the plurality of suppression blocks 413 include a plurality of first suppression blocks 413a. The first suppression blocks 413a extend in the first direction above the gap 23, and a projection, on the plane in which the piezoelectric substrate 10 is located, of the first suppression block 413a partially overlaps with a projection, on the plane in which the piezoelectric substrate 10 is located, of the electrode finger 22 located on a different side of the first suppression block 413a. In other words, the projection, on the plane in which the piezoelectric substrate 10 is located, of the first suppression block 413a of the suppression unit 41 connected to the busbar 21 in one interdigital electrode partially overlaps with the projection, on the plane in which the piezoelectric substrate 10 is located, of the electrode finger 22 of the other interdigital electrode.

As an example, as shown in FIG. 24 and FIG. 25, the plurality of suppression blocks 413 further include a plurality of second suppression blocks 413b. The second suppression blocks 413b extend in the first direction along above the electrode fingers 22 located on a same side as the second suppression blocks 413b. In other words, the second suppression blocks 413b of the suppression unit 41 connected to the busbar 21 of one interdigital electrode extend in the first direction along above the electrode fingers 22 of the one interdigital electrode. In a same suppression unit 41, the plurality of first suppression blocks 413a and the plurality of second suppression blocks 413b are alternately disposed. The first suppression block 413a of one suppression unit 41 and the second suppression block 413b of another suppression unit 41 are disposed opposite to each other. The first suppression block 413a and the second suppression block 413b have a same morphology, as shown in FIG. 24, or the first suppression block 413a and the second suppression block 413b have different morphologies, as shown in FIG. 25.

As an example, ends, close to the busbar 21, of the plurality of suppression blocks 413 are interconnected. For example, as shown in FIG. 27, the ends, close to the busbar 21, of the plurality of suppression blocks 413 are interconnected by two partial suppression units 41 similar to right triangles. That is, each suppression block 413 is connected to the busbar 21 by the partial suppression unit 41. As shown in FIG. 24, the plurality of suppression blocks 413 are separate from each other at the end close to the busbar 21, namely each suppression block 413 directly contacts the busbar 21.

In the resonator having a lateral mode suppression structure according to this embodiment, based on the resonator structures described in Embodiment 1 and Embodiment 2, the structure of the suppression unit is diversely designed, to further improve operating performance of the resonator.

### Embodiment 5

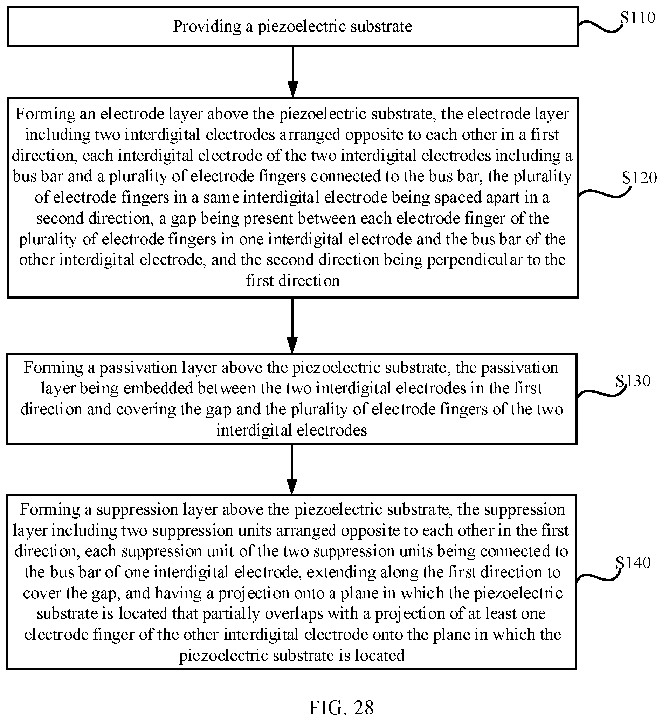

The present application also provides a method for manufacturing a resonator having a transverse-mode suppression structure. The manufacturing method is used to manufacture the resonator structures described in Embodiments 1 to 4 and other suitable resonator structures. As shown in FIG. 28, the manufacturing method includes the following steps:
Step S110, providing a piezoelectric substrate;
Step S120, forming an electrode layer above the piezoelectric substrate, the electrode layer including two interdigital electrodes arranged opposite to each other in a first direction, each interdigital electrode of the two interdigital electrodes including a busbar and a plurality of electrode fingers connected to the busbar, the plurality of electrode fingers in a same interdigital electrode being spaced apart in a second direction, a gap being present between each electrode finger of the plurality of electrode fingers in one interdigital electrode and the busbar of the other interdigital electrode, and the second direction being perpendicular to the first direction;
Step S130, forming a passivation layer above the piezoelectric substrate, the passivation layer being embedded between the two interdigital electrodes in the first direction and covering the gap and the plurality of electrode fingers of the two interdigital electrodes; and
Step S140, forming a suppression layer above the piezoelectric substrate, the suppression layer including two suppression units arranged opposite to each other in the first direction, each suppression unit of the two suppression units being connected to the busbar of one interdigital electrode, extending along the first direction to cover the gap, and having a projection onto a plane in which the piezoelectric substrate is located that partially overlaps with a projection of at least one electrode finger of the other interdigital electrode onto the plane in which the piezoelectric substrate is located.

The method for manufacturing the resonator having the transverse-mode suppression structure of this embodiment can effectively improve performance of the resonator structure without a special high-resolution process, has simple process steps and low cost, and can therefore implement mass production of a high-performance resonator.

In summary, in the resonator having the transverse-mode suppression structure of the present application, the additionally provided suppression layer structure achieves suppression of a transverse mode through energy confinement while also improving a quality factor of the resonator. The additionally provided suppression layer structure is applicable to various resonator structures and a wide frequency range, and does not require special high-resolution processes during manufacturing, thus having a simple structure and mature manufacturing processes. Furthermore, after further improvement and optimization of the suppression layer structure, a piston mode effect can be achieved without using a hammerhead structure or a selective removal method, reducing scattering loss. Additionally, selection of a material for the suppression layer allows the suppression layer to act as a heat sink due to its good thermal conductivity, in addition to a suppression effect of a transverse mode, thereby improving durability and linearity of the resonator, and consequently enhancing operational stability and service life of the resonator. The method for manufacturing the resonator having the transverse-mode suppression structure of the present application can effectively improve performance of the resonator structure without requiring special high-resolution processes. The process steps are simple and cost is low, thereby enabling mass production of high-performance resonators. Therefore, the present application effectively overcomes various shortcomings in the related art and has high industrial applicability.

The above embodiments are merely illustrative of the principles and effects of the present application and are not intended to limit the present application. Anyone skilled in the art can modify or change the above embodiments without departing from the spirit and scope of the present application. Therefore, all equivalent modifications or changes made by persons having ordinary knowledge in the technical field without departing from the spirit and technical ideas disclosed in the present application shall be covered by the claims of the present application.

## Claims

1. A resonator having a transverse-mode suppression structure, **characterized by** comprising:
a piezoelectric substrate;
an electrode layer located above the piezoelectric substrate, the electrode layer comprising two interdigital electrodes arranged opposite to each other in a first direction, each interdigital electrode of the two interdigital electrodes comprising a busbar and a plurality of electrode fingers connected to the busbar, the plurality of electrode fingers in a same interdigital electrode being spaced apart in a second direction, a gap being present between each electrode finger of the plurality of electrode fingers in one interdigital electrode and the busbar of the other interdigital electrode, and the second direction being perpendicular to the first direction;
a passivation layer located above the piezoelectric substrate, the passivation layer being embedded between the two interdigital electrodes in the first direction and covering the gap and the plurality of electrode fingers of the two interdigital electrodes; and
a suppression layer located above the piezoelectric substrate, the suppression layer comprising two suppression units arranged opposite to each other in the first direction, each suppression unit of the two suppression units being connected to the busbar of one interdigital electrode, extending along the first direction to cover the gap, and having a projection onto a plane in which the piezoelectric substrate is located that partially overlaps with a projection of at least one electrode finger of the other interdigital electrode onto the plane in which the piezoelectric substrate is located.

2. The resonator having the transverse-mode suppression structure according to claim 1, wherein when a spacing between two adjacent electrode fingers in a same interdigital electrode is λ, a width, in the first direction, of a portion in which the projection of the suppression unit on the plane in which the piezoelectric substrate is located partially overlaps with the projection of the at least one electrode finger of the other interdigital electrode on the plane in which the piezoelectric substrate is located is in a range of 0 to 1.0λ.

3. The resonator having the transverse-mode suppression structure according to claim 1 or 2, wherein a thickness, in a vertical direction, of a portion of the suppression unit located above the gap and above the at least one electrode finger of the other interdigital electrode is in a range of 1 to 100 nm, and the vertical direction is perpendicular to both the first direction and the second direction.

4. The resonator having the transverse-mode suppression structure according to any one of claims 1 to 3, wherein the suppression unit is connected to a surface of the busbar of the one interdigital electrode facing away from the piezoelectric substrate and extends to above the passivation layer.

5. The resonator having the transverse-mode suppression structure according to claim 4, wherein in the vertical direction, a thickness of a portion of the suppression unit located above the busbar of the one interdigital electrode is greater than or equal to a thickness of a portion of the suppression unit located above the passivation layer.

6. The resonator having the transverse-mode suppression structure according to claim 4 or 5, wherein the suppression unit is further embedded in the passivation layer in the vertical direction, and a portion of the suppression unit embedded in the passivation layer in the vertical direction is located above the gap.

7. The resonator having the transverse-mode suppression structure according to any one of claims 1 to 3, wherein the suppression unit is connected to a side surface of the busbar of the one interdigital electrode and is embedded in the passivation layer in the first direction.

8. The resonator having the transverse-mode suppression structure according to any one of claims 1 to 7, wherein a portion of the suppression unit located above the gap has at least one blind slot, and each blind slot of the at least one blind slot opens from a surface of the suppression unit facing the piezoelectric substrate and/or a surface of the suppression unit facing away from the piezoelectric substrate, and extends in the vertical direction.

9. The resonator having the transverse-mode suppression structure according to any one of claims 1 to 8, wherein a portion of the suppression unit located above the gap has at least one through slot, each through slot of the at least one through slot opens from a surface of the suppression unit facing away from the piezoelectric substrate, and the at least one through slot exposes at least a portion of at least one electrode finger of the one interdigital electrode.

10. The resonator having the transverse-mode suppression structure according to any one of claims 1 to 9, wherein the passivation layer has a groove, a projection of the groove on the plane in which the piezoelectric substrate is located is located between projections of the two suppression units on the plane in which the piezoelectric substrate is located, and a portion of the passivation layer surrounding the groove constitutes a raised frame.

11. The resonator having the transverse-mode suppression structure according to any one of claims 1 to 10, wherein a portion of the suppression unit located above the gap and above the at least one electrode finger of the other interdigital electrode comprises a plurality of suppression blocks spaced apart in the second direction, and a projection of at least one suppression block of the plurality of suppression blocks on the plane in which the piezoelectric substrate is located partially overlaps with the projection of the at least one electrode finger of the other interdigital electrode on the plane in which the piezoelectric substrate is located.

12. The resonator having the transverse-mode suppression structure according to claim 11, wherein the plurality of suppression blocks comprises a plurality of first suppression blocks, the plurality of first suppression blocks extend in the first direction above the gap, and projections of the plurality of first suppression blocks on the plane in which the piezoelectric substrate is located partially overlap with the projection of the at least one electrode finger of the other interdigital electrode on the plane in which the piezoelectric substrate is located.

13. The resonator having the transverse-mode suppression structure according to claim 12, wherein the plurality of suppression blocks further comprises a plurality of second suppression blocks, and the plurality of second suppression blocks extend in the first direction above an electrode finger of the one interdigital electrode.

14. The resonator having the transverse-mode suppression structure according to claim 13, wherein in a same suppression unit, the plurality of first suppression blocks and the plurality of second suppression blocks are alternately arranged, and in different suppression units, the plurality of first suppression blocks and the plurality of second suppression blocks are arranged opposite to each other, and the plurality of first suppression blocks and the plurality of second suppression blocks have a same morphology.

15. The resonator having the transverse-mode suppression structure according to claim 13, wherein in a same suppression unit, the plurality of first suppression blocks and the plurality of second suppression blocks are alternately arranged, and in different suppression units, the plurality of first suppression blocks and the plurality of second suppression blocks are arranged opposite to each other, and the plurality of first suppression blocks and the plurality of second suppression blocks have different morphologies.

16. The resonator having the transverse-mode suppression structure according to any one of claims 1 to 15, wherein the interdigital electrode further comprises a plurality of dummy fingers connected to the busbar, and in a same interdigital electrode, the plurality of dummy fingers and the plurality of electrode fingers are alternately arranged at intervals, the plurality of dummy fingers are embedded in the gap, and a preset distance exists between the plurality of dummy fingers of one interdigital electrode and the plurality of electrode fingers of the other interdigital electrode.

17. The resonator having the transverse-mode suppression structure according to any one of claims 1 to 16, wherein a material of the suppression layer comprises at least one of a metallic material and a high-density dielectric material, the metallic material comprises at least one of Al, Ti, Cu, Pt, and Au, and the high-density dielectric material comprises at least one of Ta₂O₅, HfO₂, and BaTiO₃.

18. A method for manufacturing a resonator having a transverse-mode suppression structure, **characterized by** comprising:
providing a piezoelectric substrate;
forming an electrode layer above the piezoelectric substrate, the electrode layer comprising two interdigital electrodes arranged opposite to each other in a first direction, each interdigital electrode of the two interdigital electrodes comprising a busbar and a plurality of electrode fingers connected to the busbar, the plurality of electrode fingers in a same interdigital electrode being spaced apart in a second direction, a gap being present between each electrode finger of the plurality of electrode fingers in one interdigital electrode and the busbar of the other interdigital electrode, and the second direction being perpendicular to the first direction;
forming a passivation layer above the piezoelectric substrate, the passivation layer being embedded between the two interdigital electrodes in the first direction and covering the gap and the plurality of electrode fingers of the two interdigital electrodes; and
forming a suppression layer above the piezoelectric substrate, the suppression layer comprising two suppression units arranged opposite to each other in the first direction, each suppression unit of the two suppression units being connected to the busbar of one interdigital electrode, extending along the first direction to cover the gap, and having a projection onto a plane in which the piezoelectric substrate is located that partially overlaps with a projection of at least one electrode finger of the other interdigital electrode onto the plane in which the piezoelectric substrate is located.
